# EUROPEAN PATENT SPECIFICATION

(11) **EP 4 227 698 B1**
(45) Date of publication and mention of the grant of the patent: **25.11.2026**
(21) Application number: 22870192.6
(22) Date of filing: 06.09.2022
(51) Int. Cl.: G01R 31/389, G01R 31/385, G01R 31/36, G01R 31/3842, H01M 10/48

(54) **CHARGING/DISCHARGING JIG FOR MEASURING BATTERY CELL IMPEDANCE**
LADE-/ENTLADEVORRICHTUNG ZUR MESSUNG DER IMPEDANZ EINER BATTERIEZELLE
DISPOSITIF DE MONTAGE DE CHARGE/DÉCHARGE POUR MESURE DE L'IMPÉDANCE D'UNE CELLULE DE BATTERIE

(30) Priority: 17.09.2021 KR 20210124886
(43) Date of publication of application: 16.08.2023
(73) Proprietor: LG Energy Solution, Ltd., Seoul 07335 (KR)
(72) Inventor: KIM, Ki Hyun, Daejeon 34122 (KR)
(74) Representative: Goddar, Heinz J.
(86) International application number: PCT/KR2022/013320
(87) International publication number: WO 2023/043107

(56) References cited:
- EP-A1- 4 194 869
- CN-B- 111 781 525
- CN-U- 213 780 321
- KR-A- 20080 074 240
- KR-A- 20200 017 367
- KR-B1- 101 447 435
- KR-B1- 102 146 945

## Description

### [Technical Field]

The present invention relates to a charging and discharging jig for impedance measurement of a battery cell.

This application claims the benefit of priority based on Korean Patent Application No. 10-2021-0124886, filed on September 17, 2021.

### [Background Art]

Recently, secondary batteries capable of charging and discharging have been widely used as energy sources of wireless mobile devices. In addition, secondary batteries have attracted attention as an energy source of an electric vehicle, a hybrid electric vehicle, etc., which are proposed as a solution to air pollution of existing gasoline vehicles and diesel vehicles using fossil fuel. Therefore, the types of applications using secondary batteries are currently becoming much more diverse due to the advantages of secondary batteries, and secondary batteries are expected to be applied to many fields and products in the future.

Such secondary batteries may be classified into lithium ion batteries, lithium ion polymer batteries, lithium polymer batteries, etc., depending on the composition of the electrolyte and the electrode, and among them, the use of lithium-ion polymer batteries that are less likely to leak electrolyte and are easy to manufacture is increasing. In general, secondary batteries are classified depending on the shape of a battery case into cylindrical batteries and prismatic batteries in which an electrode assembly is embedded in a cylindrical or prismatic metal can, and pouch-type batteries in which the electrode assembly is embedded in a pouch-type case of an aluminum laminate sheet. The electrode assembly embedded in the battery case is composed of a positive electrode, a negative electrode, and a separator interposed between the positive electrode and the negative electrode, and is a power generating element capable of charging and discharging. The electrode assembly is classified into a jelly-roll type wound with a separator interposed between a positive electrode and a negative electrode which are long sheet-shaped and are coated with active materials, or a stack type in which a plurality of positive electrodes and negative electrodes of a predetermined size are sequentially stacked with separators interposed therebetween.

In order to inspect the safety and performance of such secondary batteries, various tests may be performed. Among them, a method of evaluating the safety and performance of a battery by measuring the impedance of the battery cell is being relied upon more and more. By measuring the impedance of the battery cell in this way, main factors such as life, capacity, and charge state can be estimated.

The measurement results of impedance of a battery cell vary depending on the length change or movement of a measuring conducting line (wire). In the case of a cylindrical battery with a short length and a large impedance value, the influence of a wire is relatively less, but in the case of a medium- or large-sized pouch-type battery with a long length and a small impedance value, the measured impedance value has a large deviation according to the length or movement of a wire. The impedance of such a battery cell can be measured by installing a battery cell in a charging and discharging jig that can be displaced in a longitudinal direction of the battery cell.

Specifically, the impedance is measured by installing leads each having different polarities of a battery cell on charging and discharging bus bars installed on both sides of a charging and discharging jig, and connecting wires to the charging and discharging bus bars.

Conventionally, the impedance of a battery cell was measured by installing a battery cell and a charging and discharging jig for impedance measurement in which the battery cell is installed in a temperature chamber, and connecting an impedance measuring device (for example, an EIS measuring device) and the charging and discharging jig with a conducting line from the outside. Since the impedance measuring device and the charging and discharging jig occupy a large volume, there has been difficulty installing the impedance measuring device and the charging and discharging jig in the temperature chamber. Thus, when the impedance measuring device is installed outside the temperature chamber, the length of the conducting line connecting the battery cell and the impedance measuring device naturally increases. Thus, as the length of the conducting line increases, the impedance component (inductance) according to the length of the conducting line increases, which acts as noise in the impedance measurement of the battery cell, making it difficult to accurately measure the impedance of the battery cell. Moreover, when the conducting line is extended outside the battery cell at length, a magnetic field caused by the current flowing through the battery cell and a magnetic field caused by the conducting line cannot be offset, and therefore an impedance disturbance effect due to the noise caused by this magnetic field inevitably occurs. This problem is more serious in the case of a medium- or large-sized pouch type battery having a long battery cell length and a small impedance value.

Hence, there is a need to develop a device capable of more accurately measuring the impedance of a battery cell by reducing the effect of a magnetic field caused by the current of the battery cell and a conducting line while reducing the length of the conducting line for impedance measurement.

### [Prior-art Document]

Korean Registered Patent Publication No. 10-1359902

KR 101 447 435 B1 describes a battery jig including a lower bus bar in contact with one side of an electrode tab of a battery, an upper bus bar in contact with the other side of the electrode tab of the battery, and a plurality of grooves formed on the facing surfaces of the upper bus bar and the lower bus bar. A plurality of contact surfaces are provided on the facing surfaces of the lower bus bar and the upper bus bar.

### [Disclosure]

### [Technical Problem]

The present invention is directed to providing a charging and discharging jig for impedance measurement of a battery cell in which a conducting line for impedance measurement can be formed short and the conducting line can be installed to extend in parallel with the battery cell while facing the battery cell.

### [Technical Solution]

The present invention is defined by the subject matter of the appended independent claim. Particular embodiments are given by the features of the appended dependent claims. A charging and discharging jig for impedance measurement of a battery cell includes: a jig body on which a battery cell is mounted in a longitudinal direction; a first bus bar and a second bus bar installed on top of both sides of the jig body and to which lead parts of both ends of the battery cell are each coupled; an impedance measuring board installed in the jig body; and a conducting line for impedance measurement connecting the first bus bar, the impedance measuring board, and the second bus bar to constitute an impedance measuring circuit, and a part of the conducting line for impedance measurement has a part facing a wide surface of the battery cell and extending in the longitudinal direction of the battery cell.

The conducting line for impedance measurement may include a signal line configured to apply an AC signal to the battery cell and a sensing line configured to measure a voltage of the battery cell.

For example, the first bus bar and the second bus bar may each be constituted as an upper bus bar and a lower bus bar, and the conducting line for impedance measurement may be connected to the upper bus bar or the lower bus bar.

As a specific example, the upper bus bars of the first bus bar and the second bus bar may each be separated into two bus bars, and the signal line and the sensing line may be connected to each of the separated bus bars.

As an example, the impedance measuring board may include an AC signal source and an ammeter connected to the signal line, and a voltmeter connected to the sensing line.

Specifically, the impedance measuring board is installed on a lower part of the jig body, and the conducting line for impedance measurement constitutes a loop connecting the first bus bar, the impedance measuring board, and the second bus bar, and a part of the conducting line constituting the loop extend in the longitudinal direction of the battery cell along a bottom surface of the jig body.

As another example, the charging and discharging jig may further include pedestals installed on both lower sides of the jig body, and the impedance measuring board may be installed on the pedestal or the lower part of the jig body adjacent to the pedestals.

As another example, the charging and discharging jig may further include pedestals installed on both lower sides of the jig body, and the impedance measuring board may be installed on a measuring board support coupled to the pedestals.

As another example, a conducting line support member configured to support the conducting line for impedance measurement extending in the longitudinal direction of the battery cell along the bottom surface of the jig body may be installed on the bottom surface of the jig body.

As another example, fixing jigs configured to fix both sides of a conducting line extending in the longitudinal direction of the battery cell along the bottom surface of the jig body may be installed on both sides of the bottom surface of the jig body.

The impedance measuring board is installed in the middle of the bottom surface of the jig body, and the part of the conducting line constituting the loop is drawn out to both sides of the impedance measuring board and extend toward each of the first bus bar and the second bus bar.

As another exemplary embodiment of the present invention, the jig body may include a fixed block and a movable block slidably coupled to the fixed block, the first bus bar may be installed on one side of the fixed block, and the second bus bar may be installed on one side of the movable block.

As an example, the movable block may be slidably coupled to an upper surface of the fixed block.

As a specific example, guide slits may be formed on both sides in a width direction of one of the fixed block and the movable block, and sliding support members inserted into the guide slits may be installed in the other of the fixed block and the movable block.

More specifically, each of the sliding support members may have a body part inserted into the guide slit and screwed to the fixed block or the movable block, and a head part having a width greater than that of the guide slit.

### [Advantageous Effects]

According to the present invention, by reducing the length of a conducting line for impedance measurement, the influence of an inductance according to the length of a wire can be minimized, thereby reducing the noise of impedance measurement.

In addition, since a conducting line for impedance measurement has a structure that can be installed to face a wide surface of a battery cell and extend in a longitudinal direction of the battery cell, the impedance of the battery cell can be more accurately measured by offsetting a magnetic field caused by the battery cell and a magnetic field caused by the conducting line.

### [Brief Description of the Drawings]

FIG. 1 is a schematic diagram illustrating a difference between impedance measuring mechanisms by a conventional impedance measuring device and a charging and discharging jig for impedance measurement not forming part of the present invention.
FIG. 2 is a perspective view of a charging and discharging jig for impedance measurement of a battery cell according to one illustrative example not forming part.
FIG. 3 is a schematic diagram illustrating a connection relationship between a conducting line for impedance measurement and an impedance measuring board and an impedance measuring circuit constituted by the conducting line and the measuring board not forming part of the present invention.
FIG. 4 is a bottom view of the charging and discharging jig for impedance measurement of FIG. 2.
FIG. 5 is a bottom view of a charging and discharging jig for impedance measurement of a battery cell according to another illustrative example not forming part of the present invention.
FIG. 6 is a bottom view of a charging and discharging jig for impedance measurement of a battery cell according to still another exemplary embodiment of the present invention.
FIG. 7 is a perspective view of a charging and discharging jig for impedance measurement of a battery cell according to another illustrative example not forming part of the present invention.
FIG. 8 is a bottom view of the charging and discharging jig for impedance measurement of FIG. 7.

### [Best Mode]

Hereinafter, the detailed configuration of the present invention will be described in detail with reference to the accompanying drawings and various exemplary embodiments. The exemplary embodiments described below are illustratively shown to help with understanding of the present invention, the accompanying drawings may not be illustrated on an actual scale but sizes of some components may be exaggerated in order to help with understanding of the present invention.

In the present invention, since various modifications may be made and various forms may be applied, specific exemplary embodiments are illustrated in the drawings and described in detail in the text. However, this is not intended to limit the present invention to the specific disclosed forms, which should be understood to include all modifications and equivalents included in the scope of the present invention.

As described above, the present invention provides a charging and discharging jig for impedance measurement of a battery cell 10 in which a conducting line L for impedance measurement can be formed short and the conducting line can be installed to extend in parallel with the battery cell 10 while facing the battery cell 10.

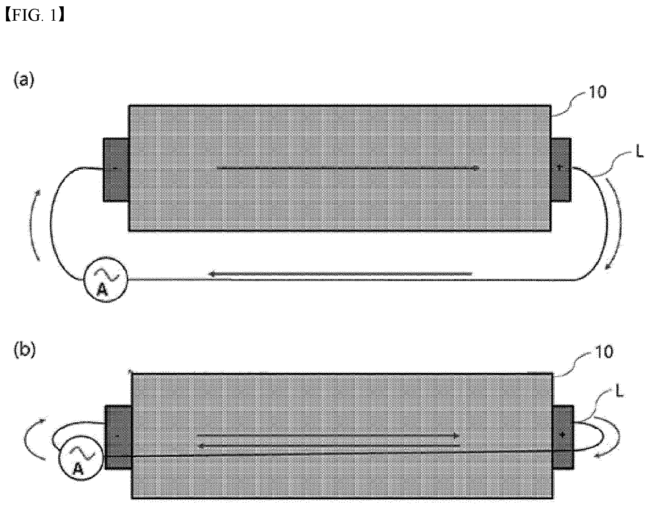

FIG. 1 is a schematic diagram illustrating a difference between impedance measuring mechanisms by a conventional impedance measuring device and an impedance measuring board 400.

Conventionally, a battery cell and a charging and discharging jig for impedance measurement are installed in a temperature chamber, and an impedance measuring device (e.g., EIS measuring device) and a charging and discharging device are installed outside the temperature chamber to charge and discharge the battery cell and measure the impedance of the battery cell at the same time. Since the impedance measuring device and the charging and discharging device occupy a significant volume, the impedance measuring device and the charging and discharging device cannot be installed in the temperature chamber due to the size limitation of the space of the temperature chamber. For this reason, the configuration of the conducting line for impedance measurement during charging and discharging of the conventional battery cell had to be as shown in FIG. 1(a). Referring to FIG. 1, when measuring the impedance of a battery cell, a conducting line constitutes a loop shape connecting both leads of the battery cell and an impedance measuring device that is not shown. In this case, as described above, when the impedance measuring device is installed outside the temperature chamber, the loop of the conducting line connected to the battery cell lead becomes longer as shown in FIG. 1(a). Accordingly, the length of the conducting line increases and an inductance component of the conducting line increases, which acts as noise when measuring the impedance of the battery cell. In addition, since the conducting line is in the form of a long extension, whenever the wire is connected to the battery cell, there is a problem that the arrangement of the wire slightly changes and the impedance measurement result changes accordingly. In addition, in the case of FIG. 1(a), a magnetic field is generated by the current flowing along the battery cell. An impedance value of the battery cell may be disturbed by this magnetic field.

On the other hand, as shown in FIG. 1(b), when the conducting line for impedance measurement is disposed adjacent to the battery cell, the length of the conducting line is shortened, and thus the influence of an inductance can be significantly reduced. In addition, in FIG. 1(b), the conducting line for impedance measurement faces a wide surface of the battery cell and extends in parallel to the longitudinal direction of the battery cell. In this case, as shown in FIG. 1(b), because the directions of the current flowing along the battery cell and the current flowing along the conducting line are opposite, the directions of the magnetic fields caused by the currents are also opposite. That is, as shown in FIG. 1(b), when the conducting line (circuit) for impedance measurement can be constituted, the magnetic fields of the battery cell and the conducting line may be offset from each other. In this case, the impedance of the battery cell may be more accurately measured without being disturbed by the magnetic fields.

The present invention significantly shortens the length of a conducting line for impedance measurement connected to a battery cell by directly installing an impedance measuring board in a charging and discharging jig for impedance measurement of the battery cell, and excludes the influence of a magnetic field by extending the conducting line as shown in FIG. 1(b).

Specific details regarding a charging and discharging jig for impedance measurement of a battery cell 10 of the present invention will be described with reference to exemplary embodiments and drawings.

### [Mode for Invention]

### (First Example)

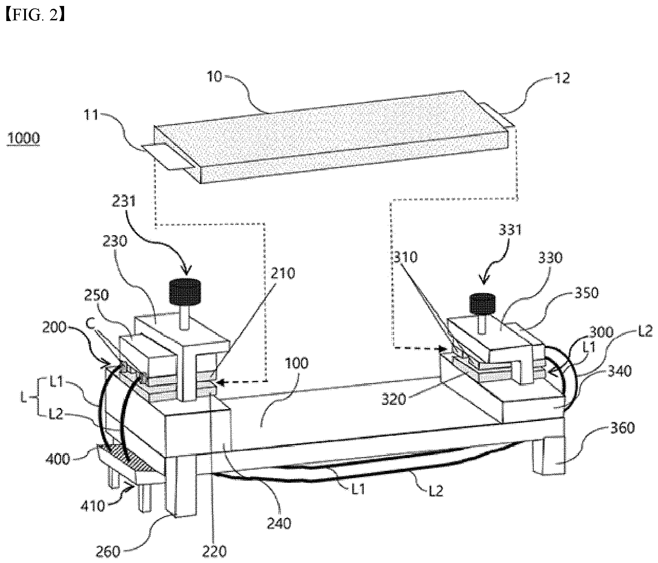

FIG. 2 shows an illustrative example of a charging and discharging jig 1000 for impedance measurement of a battery cell 10.

Referring to FIG. 2, a charging and discharging jig for impedance measurement of the battery cell 10 includes: a jig body 100 on which the battery cell 10 is mounted in a longitudinal direction; a first bus bar 200 and a second bus bar 300 installed on both sides of the jig body 100 and to which lead parts 11 and 12 of both ends of the battery cell 10 are each coupled; an impedance measuring board 400 installed in the jig body 100; and a conducting line L for impedance measurement connecting the first bus bar 200, the impedance measuring board 400, and the second bus bar 300 to constitute an impedance measuring circuit, and a part of the conducting line L for impedance measurement has a part facing a wide surface of the battery cell and extending in the longitudinal direction of the battery cell 10.

The battery cell 10 is installed in the jig body 100 in the longitudinal direction, that is, so that electrode leads at both ends are disposed on both sides of the jig body 100. In FIG. 2, the jig body 100 is in the form of a fixed jig whose length does not change. However, as will be described below, the jig body 100 may be constituted in the form of a variable jig of which the length can be adjusted in the longitudinal direction in accordance with the length of the battery cell.

First, in order to measure the impedance of the battery cell 10, the battery cell 10 is positioned on the jig body 100, and the first and second bus bars on both sides of the charging and discharging jig are connected to the lead parts 11 and 12 of the battery cell 10. The first and second bus bars are both connected to the impedance measuring board 400 through the conducting line L for impedance measurement.

The impedance measuring board 400 of the present invention corresponds to the conventional impedance measuring device, and is constituted in the form of a small substrate required for impedance measurement by greatly simplifying the detailed configuration of a complex impedance measuring device. Therefore, by being made as a small substrate, the impedance measuring board can be easily introduced into a temperature chamber when measuring the impedance in the temperature chamber. In particular, in the present invention, the impedance measuring board is installed in the jig body. As a result, the length of the conducting line for impedance measurement constituted through the leads of both ends of the battery cell and the impedance measuring board is greatly shortened. That is, since an impedance measuring unit is installed in the charging and discharging jig, there is no need to extend the conducting line at length to the outside as in the conventional art.

Specifically, the impedance measuring board 400 of the present invention includes an AC signal source S configured to transmit an AC signal to the battery cell 10, a voltmeter V configured to measure a voltage difference between both ends of the battery cell 10, and an ammeter A configured to measure a current.

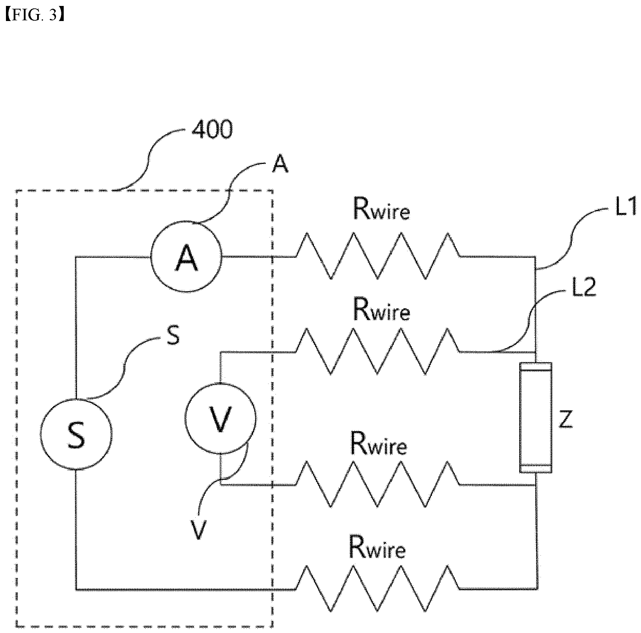

FIG. 3 illustrates a circuit for sensing voltages applied to both ends of the lead parts 11 and 12 of the battery cell 10 by a four-terminal method. Referring to this, it can be seen that the conducting line L connected to the AC signal source S and the voltmeter V is connected to both ends of the battery cell 10. The conducting line L for impedance measurement is composed of a signal line L1 configured to apply an AC signal to the battery cell and a sensing line L2 configured to measure a voltage of the battery cell. In FIG. 3, the signal line L1 and the sensing line L2 are connected to the battery cell. By applying an AC signal from the AC signal source S, an AC current is applied to the battery cell 10 through the signal line L1. Since the battery cell 10 contains a predetermined impedance component, a potential difference (voltage) is generated at both ends of the lead parts 11 and 12 of the battery cell 10 by the application of the AC current. At this time, the current moving through the conducting line L is measured by the ammeter A, and the voltage difference between both ends of the battery cell 10 may be measured by the voltmeter V. The impedance of the battery cell 10 may be measured through the measured values of the ammeter A and the voltmeter V. The ammeter A and the voltmeter V provided in the impedance measuring board 400 are connected to an external computing device or display device, so that the current and voltage may be visually expressed. The computing device may calculate the impedance of the battery cell 10 by dividing the voltage value by the AC current value, and the calculated impedance value may be displayed on the display device.

Referring back to FIG. 2, it can be seen that the first bus bar 200 and the second bus bar 300 coupled to the lead parts 11 and 12 of the battery cell 10 and the impedance measuring board 400 are connected by the signal line L1 and the sensing line L2. The signal line L1 and the sensing line L2 may be coupled to the first and second bus bars by a coupling member C or the like, respectively. The coupling member C may be a screw member for coupling the signal line and the sensing line to the bus bar, but is not limited thereto. The signal line L1 is connected to the AC signal source S and the ammeter A of the impedance measuring board 400, and the sensing line L2 is connected to the voltmeter V of the impedance measuring board 400. The AC signal source S and the ammeter A of the impedance measuring board 400 are connected to the second bus bar 300 by the signal line L1, and the voltmeter V is connected to the second bus bar 300 by the sensing line L2.

The conducting line L for impedance measurement of the present invention preferably constitutes a loop connecting the first bus bar 200, the impedance measuring board 400, and the second bus bar 300. Referring to FIG. 2, it can be seen that the conducting line L extends from the first bus bar 200 to the second bus bar 300 across the impedance measuring board 400, and a part of the conducting line L (signal line: L1 and sensing line: L2) constituting the loop extends in the longitudinal direction of the battery cell 10 along the bottom surface of the jig body 100.

Meanwhile, the charging and discharging jig of the present invention includes the first bus bar 200 and the second bus bar 300 coupled to the lead parts 11 and 12 at both ends of the battery cell 10. Referring to FIG. 2, the first and second bus bars are inserted into and positioned in bus bar coupling frames 230 and 330 in which installation holes are formed so that the bus bars may be inserted thereinto.

The first and second bus bars are composed of upper bus bars 210 and 310 and lower bus bars 220 and 320 located below the upper bus bars 210 and 310, respectively, and the conducting line L for impedance measurement is connected to the upper bus bars 210 and 310 or the lower bus bars 220 and 320. Although not shown, when the conducting line L for impedance measurement is connected to the upper bus bars 210 and 310, the lower bus bars 220 and 320 are separately connected to a charging and discharging device configured to charge and discharge the battery cell 10 by the conducting line L.

The upper bus bars 210 and 310 or the lower bus bars 220 and 320 of the first bus bar 200 and the second bus bar 300 may each be separated into two bus bars. More preferably, among the upper bus bars 210 and 310 and the lower bus bars 220 and 320, the bus bars connected to the conducting line L for impedance measurement may be separated into two bus bars again. As described above, since the present invention measures the impedance using the four-terminal method, the upper bus bar or the lower bus bar is divided into two pieces so that a plurality of conducting lines may be connected to each of the separated bus bars.

In the example of FIG. 2, the upper bus bars 210 and 310 of the first bus bar 200 and the second bus bar 300 are each separated into two bus bars, and the signal line L1 and the sensing line L2 are connected to each of the separated bus bars.

Meanwhile, insulators 250 and 350 are installed between the upper bus bars 210 and 310 and the bus bar coupling frames 230 and 330, and the insulators 250 and 350 are coupled to upper parts of the upper bus bars. Adjustment screw parts 231 and 331 on the bus bar coupling frames 230 and 330 are screw-coupled to the insulators 250 and 350 through the bus bar coupling frames 230 and 330. Therefore, when the adjustment screw parts 231 and 331 are rotated, the insulators 250 and 350 and the upper bus bars 210 and 310 are lifted up and down, and accordingly, the lead parts 11 and 12 of the battery cell 10 may be easily inserted and removed between the upper bus bars 210 and 310 and the lower bus bars 220 and 320.

The bus bar coupling frames 230 and 330 configured to fix the first and second bus bars and the insulators 250 and 350 are fixed to both sides of the jig body 100, and at this time, bus bar support members 240 and 340 may be further interposed as needed between the bus bar coupling frames 230 and 330 and the jig body 100 for adjusting the height of the bus bars and supporting the bus bar coupling frames 230 and 330.

The jig body 100 of the present invention may further include pedestals 260 and 360 installed on both lower sides thereof. The pedestals 260 and 360 are coupled to the jig body 100 and serve to stably support the jig body 100.

Another characteristic point of the present invention is that the impedance measuring board 400 is installed close to the jig body 100, so that the length of the conducting line L may be reduced as much as possible. The impedance measuring board 400 may be installed on the upper part of the jig body 100 or on the lower part of the jig body as shown in FIG. 2. According to one example, the impedance measuring board 400 is installed on the pedestals 260 and 360 or on the lower part of the jig body 100 adjacent to the pedestals 260 and 360. In this case, the impedance measuring board 400 may be screwed to the pedestals 260 and 360 or to the lower part of the jig body 100, or may be adhesively coupled. However, the present invention is not limited thereto, and it may be installed at a desired location using any means that can fix the impedance measuring board 400. According to another example, the impedance measuring board 400 may be installed on a support 410 for the impedance measuring board 400 that can support the impedance measuring board 400, and at this time, the support 410 for the impedance measuring board 400 may be preferably coupled to the pedestals 260 and 360 included on both sides of the lower part of the jig body 100.

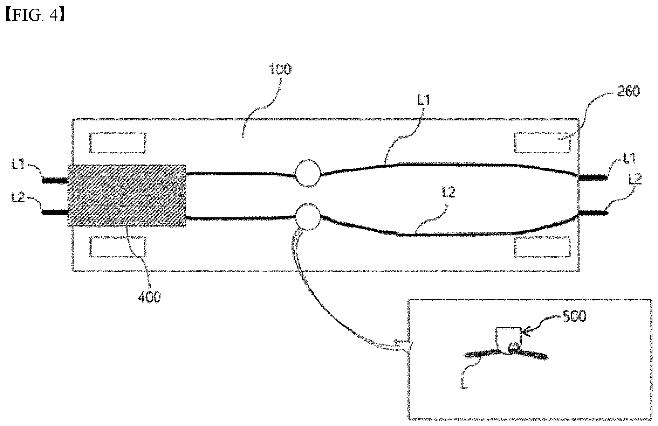

FIG. 4 is a bottom view of the charging and discharging jig for impedance measurement of FIG. 2.

As shown in FIG. 4, a support member 500 for the conducting line L configured to support a wire extending in the longitudinal direction of the battery cell 10 along the bottom surface of the jig body 100 may be installed on the bottom surface of the jig body 100. The support member 500 for the conducting line L is perforated from one side to the other side, and the conducting line L is hung through the perforation. At this time, the size of the perforation should be greater than the thickness of the conducting line L, and the movement of the conducting line L in the longitudinal direction of the battery cell 10 should not be disturbed by the support member 500 for the conducting line L. The conducting line L is reliably supported by the charging and discharging jig by the conducting line support member 500 to prevent a change in tension of the conducting line. That is, since the conducting line is stably supported by the conducting line support member and thus the length of the conducting line does not change, the accuracy of impedance measurement can be improved.

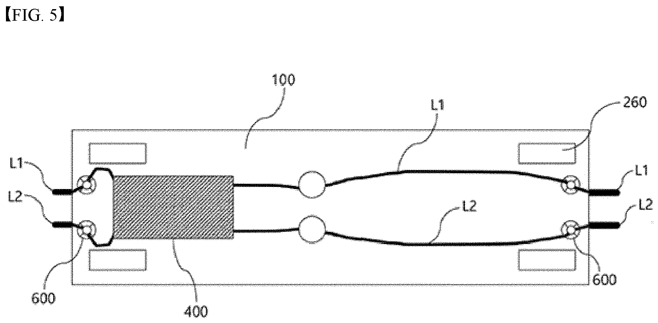

FIG. 5 is a bottom view of a charging and discharging jig for impedance measurement of a battery cell.

On the bottom surface of the jig body 100, as shown in FIG. 5, a fixing jig 600 configured to fix both sides of the conducting line L extending in the longitudinal direction of the battery cell 10 along the bottom surface of the jig body 100 may be installed. The fixing jig 600 includes a shape in which the conductive line L can be inserted, and the conductive line L inserted into the fixing jig 600 is limited in movement and fixed, unlike the support member. Impedance measurement may be easily performed by installing the fixing jig 600 at a position where the conducting line L is to be fixed, and fixing the conducting line L to the bottom of the jig body 100 by inserting the conducting line L into the fixing jig 600. The accuracy of impedance measurement is improved as the conducting line is fixedly coupled to the charging and discharging jig without floating by the conducting line support member 500 and the fixing jig.

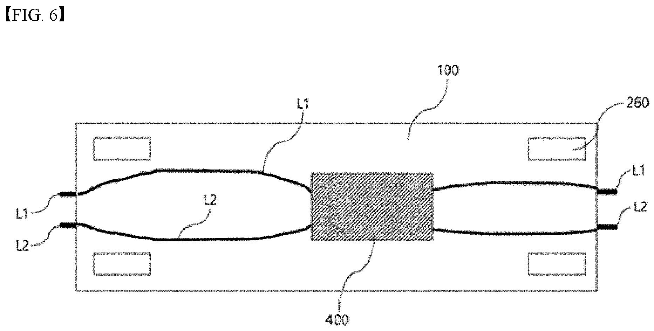

FIG. 6 is a bottom view of a charging and discharging jig for impedance measurement of a battery cell according to an embodiment of the present invention.

In this exemplary embodiment, the impedance measuring board 400 is installed in the middle of the bottom surface of the jig body 100. In the present invention, since the impedance measuring board 400 is installed in the jig body 100, the length of the conducting line for impedance measurement is shortened as described above. In this case, the impedance measuring board 400 may be installed on an upper part, a side part, and a lower part of the jig body. However, when installed on the upper part of the jig body 100, it may be an obstacle to installation of the battery cell on the jig, so that it is preferable to install the impedance measuring board on the side part or the lower part of the jig body. In addition, since the bus bars are installed on both sides of the jig body, it may be better to install the impedance measuring board on the lower part of the jig body in consideration of bus bar installation space. When the impedance measuring board is installed on the lower part the jig body 100, it may be installed on one of both sides of the jig body 100 as shown in FIG. 2. In addition, as shown in FIG. 6, it is also possible to install the impedance measuring board in the middle of the bottom surface of the jig body 100. The important thing is to measure the impedance while shortening the length of the conducting line for impedance measurement by coupling the impedance measuring board on a line in which the conducting line for impedance measurement extends.

As the impedance measuring board 400 is installed in the middle of the jig body 100, a part of the conducting line L constituting the loop is drawn out to both sides of the impedance measuring board 400 and extends toward each of the first bus bar 200 and the second bus bar 300. At this time, even if the conducting line L is drawn out to both sides of the impedance measuring board 400, a magnetic field offsetting effect can be maintained because the conducting line L is still in a position where it faces the wide surface of the battery cell 10.

### (Second Example)

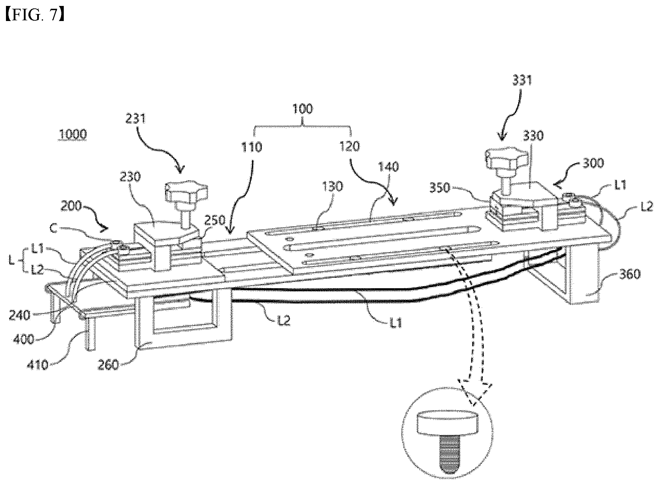

FIG. 7 is a perspective view of a charging and discharging jig for impedance measurement of a battery cell.

This example is in the form of a variable jig in which the charging and discharging jig for impedance measurement may be displaced in the longitudinal direction. By changing the length of the jig, there is an advantage that the jig length can be adjusted to match different types of battery cells.

Referring to FIG. 7, a jig body 100 includes a fixed block 110 and a movable block 120 slidably coupled to the fixed block 110, a first bus bar 200 is installed on one side of the fixed block 110, and a second bus bar 300 is installed on one side of the movable block 120.

The jig body 100 can be variably deformed to measure an impedance in accordance with the length of the battery cell 10. Specifically, the jig body 100 includes the fixed block 110 and the movable block 120 sliding in the longitudinal direction of the battery cell 10 with respect to the fixed block 110. Among the conducting lines L used at this time, a conducting line L extending along the bottom surface of the jig body 100 should be installed assuming that the fixed block 110 and the movable block 120 are as far away as possible so that the jig body 100 can be freely deformed. The movable block 120 may be slidably coupled to any one of the bottom surface and the upper surface of the fixed block 110. However, in this case, between two blocks, it is preferable that an impedance measuring board 400 be installed on the bottom surface of the block located lower than the other block. When the movable block 120 is slidably coupled to the upper surface of the fixed block 110 as shown in FIG. 7, the impedance measuring board 400 is installed on the lower surface of the fixed block 110 located relatively lower. Coupling by sliding of the movable block 120 and the fixed block 110 may be performed by coupling guide slits 140 and sliding support members 130. For example, the guide slits 140 may be formed on both sides in a width direction of one of the fixed block 110 and the movable block 120, and the sliding support members 130 inserted into the guide slits may be installed on the other of the fixed block 110 and the movable block 120. As the sliding support members 130 slide along the guide slits 140, the movable block 120 may slide along the fixed block 110. At this time, the guide slits 140 may be installed in any one of the fixed block 110 and the movable block 120. In the example of FIG. 7, the guide slits 140 are formed on both sides of the movable block 120 in the width direction, and the sliding support members 130 are formed on both sides of the fixed block 110 in the width direction. Each of the sliding support members 130 may have a body part inserted into the guide slit 140 and screwed to the fixed block 110 or screwed to the movable block 120, and a head part having a width greater than that of the guide slit. Since the head part has a width greater than that of the guide slit 140, separation of the sliding support member 130 from the guide slit 140 may be prevented, and thus separation of the movable block 120 from the fixed block 110 may be prevented. In addition, since the body part of the sliding support member 130 has a screw thread and is screw-coupled to the fixed block 110 or the movable block 120, the movable block 120 may be fixed to the fixed block 110 by adjusting the degree of the screw coupling. That is, after the movement of the movable block 120 is completed, when the sliding support member 130 is further rotated to move the head part downward, the head part presses edges of both sides of the guide slit 140 so that the movable block 120 may be fixed to the fixed block 110.

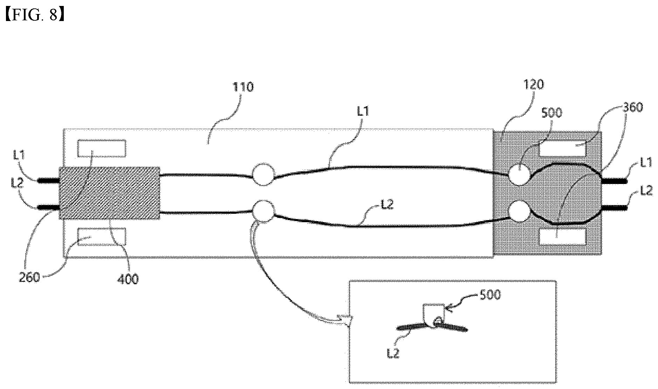

FIG. 8 is a bottom view of the charging and discharging jig for impedance measurement of FIG. 7.

FIG. 8 shows an example in which a support member 500 for the conducting line L is applied to the charging and discharging jig for impedance measurement of the battery cell 10. In order to maintain the effect of offsetting the magnetic field generated in the battery cell 10, the conducting line L should deviate as little as possible from the wide surface range of the battery cell 10. The support member 500 for the conducting line L is installed at an appropriate position when the movable block 120 slides on the fixed block 110 and the deformation of the conducting line L increases, thereby minimizing the deformation of the conducting line L. However, it is necessary to avoid the installation of the support member 500 for the conducting line L on a sliding path so that the sliding of the movable block 120 is not disturbed by the support member 500 for the conducting line L. As shown in FIG. 8, the conducting line can be maintained in the jig without sagging by installing the support member 500 in the middle and on one side of the jig, and installing the impedance measuring board on the other side to connect the conducting line. In addition, when the movable block moves, the conducting line may inevitably sag downward, but since the conducting line is supported by the plurality of support members 500, the degree of sagging can be reduced. Also in this example, since a part of the conducting line extends in the longitudinal direction of the battery cell, as shown in FIG. 1(b), the magnetic field caused by the current flowing in the battery cell may be offset by the magnetic field caused by the conducting line.

**[Description of Reference Numerals]**

| | | | |
|---|---|---|---|
| 10, Z: | battery cell | | |
| 11, 12: | lead parts | L: | conducting line |
| 100: | jig body | L1: | signal line |
| 110: | fixed block | L2: | sensing line |
| 120: | movable block | A: | ammeter |
| 130: | sliding support member | V: | voltmeter |
| 140: | guide slit | S: | AC signal source |
| 200: | first bus bar | R_{wire}: | conducting line resistance |
| 300: | second bus bar | | |
| 210, 310: | upper bus bars | C: | coupling member |
| 220, 320: | lower bus bars | | |
| 230, 330: | bus bar coupling frames | | |
| 231, 331: | adjustment screw parts | | |
| 240, 340: | bus bar support members | | |
| 250, 350: | insulators | | |
| 260, 360: | pedestals | | |
| 400: | impedance measuring board | | |
| 410: | supportfor the impedance measuring board | | |
| 500: | supportmember for the conducting line | | |
| 600: | fixingjig | | |

## Claims

1. A charging and discharging jig for impedance measurement of a battery cell (10), the charging and discharging jig comprising:
a jig body (100) on which a battery cell (10) is mounted in a longitudinal direction; and
a first bus bar (200) and a second bus bar (300) installed on a top surface at both sides of the jig body (100) and to which lead parts (11, 12) of both ends of the battery cell (10) are each coupled,
**characterized by**
an impedance measuring board (400) installed in the jig body (100); and
a conducting line (L) for impedance measurement connecting the first bus bar (200), the impedance measuring board (400), and the second bus bar (300) to constitute an impedance measuring circuit,
wherein a part of the conducting line (L) for impedance measurement has a part facing a wide surface of the battery cell (10) and extending in the longitudinal direction of the battery cell (10),
wherein the impedance measuring board (400) is installed in the middle of the bottom surface of the jig body (100) in the longitudinal direction, the conducting line (L) for impedance measurement constitutes a loop connecting the first bus bar (200), the impedance measuring board (400), and the second bus bar (300), and a part of the conducting line (L) constituting the loop extends in the longitudinal direction of the battery cell (10) along a bottom surface of the jig body (100),
wherein the impedance measuring board (400) is installed on the bottom surface of the jig body (100), and the part of the conducting line (L) constituting the loop is drawn out to both sides of the impedance measuring board (400) and extends toward each of the first bus bar (200) and the second bus bar (300).

2. The charging and discharging jig of claim 1, wherein the conducting line for impedance measurement includes a signal line (L1) configured to apply an AC signal to the battery cell (10), and a sensing line (L2) configured to measure a voltage of the battery cell (10).

3. The charging and discharging jig of claim 2, wherein the first bus bar (200) and the second bus bar (300) are each constituted as an upper bus bar (210, 310) and a lower bus bar (220, 320), and the conducting line (L) for impedance measurement is connected to the upper bus bar (210, 310) or the lower bus bar (220, 320).

4. The charging and discharging jig of claim 3, wherein the upper bus bars (210, 310) of the first bus bar (200) and the second bus bar (300) are each separated into two bus bars, and the signal line (L1) and the sensing line (L2) are connected to each of the separated bus bars.

5. The charging and discharging jig of claim 2, wherein the impedance measuring board (400) includes an AC signal source (S) and an ammeter (A) connected to the signal line (L1), and a voltmeter (V) connected to the sensing line (L2).

6. The charging and discharging jig of claim 1, further comprising pedestals (260, 360) installed on both lower sides of the jig body (100), wherein the impedance measuring board (400) is installed on the pedestals (260, 360) or the lower part of the jig body (100) adjacent to the pedestals (260, 360).

7. The charging and discharging jig of claim 1, further comprising pedestals (260, 360) installed on both lower sides of the jig body (100), wherein the impedance measuring board (400) is installed on a measuring board support (410) coupled to the pedestals (260, 360).

8. The charging and discharging jig of claim 1, wherein a conducting line support member (500) configured to support the conducting line (L) for impedance measurement extending in the longitudinal direction of the battery cell (10) along the bottom surface of the jig body (100) is installed on the bottom surface of the jig body (100).

9. The charging and discharging jig of claim 1, wherein fixing jigs (600) configured to fix both sides of a conducting line (L) extending in the longitudinal direction of the battery cell (10) along the bottom surface of the jig body (100) are installed on both sides of the bottom surface of the jig body (100).

10. The charging and discharging jig of claim 1, wherein the jig body (100) includes a fixed block (110) and a movable block (120) slidably coupled to the fixed block (110), and
the first bus bar (200) is installed on one side of the fixed block (110) and the second bus bar (300) is installed on one side of the movable block (120).

11. The charging and discharging jig of claim 10, wherein the movable block (120) is slidably coupled to an upper surface of the fixed block (110).

12. The charging and discharging jig of claim 11, wherein guide slits (140) are formed on both sides in a width direction of one of the fixed block (110) and the movable block (120), and
sliding support members (130) inserted into the guide slits (140) are installed on the other of the fixed block (110) and the movable block (120).

13. The charging and discharging jig of claim 12, wherein each of the sliding support members (130) has a body part inserted into the guide slit (140) and screwed to the fixed block (110) or the movable block (120), and a head part having a width greater than that of the guide slit (140).

## Patentansprüche

1. Lade- und Entladevorrichtung zur Impedanzmessung einer Batteriezelle (10), wobei die Lade- und Entladevorrichtung aufweist:
einen Spannvorrichtungskörper (100), an dem eine Batteriezelle (10) in einer Längsrichtung angebracht ist; und
eine erste Sammelschiene (200) und eine zweite Sammelschiene (300), die an einer oberen Fläche an beiden Seiten des Spannvorrichtungskörpers (100) installiert sind und an die jeweils Leitungsteile (11, 12) beider Enden der Batteriezelle (10) gekoppelt sind,
**gekennzeichnet durch**
eine Impedanzmessplatte (400), die in dem Spannvorrichtungskörper (100) installiert ist; und
eine leitfähige Leitung (L) zur Impedanzmessung, die die erste Sammelschiene (200), die Impedanzmessplatte (400) und die zweite Sammelschiene (300) verbindet, um eine Impedanzmessschaltung zu bilden,
wobei ein Teil der leitfähigen Leitung (L) zur Impedanzmessung einen Teil aufweist, der einer breiten Fläche der Batteriezelle (10) zugewandt ist und sich in der Längsrichtung der Batteriezelle (10) erstreckt,
wobei die Impedanzmessplatte (400) in der Mitte der unteren Fläche des Spannvorrichtungskörpers (100) in der Längsrichtung installiert ist, die leitfähige Leitung (L) zur Impedanzmessung eine Schleife bildet, die die erste Sammelschiene (200), die Impedanzmessplatte (400) und die zweite Sammelschiene (300) verbindet, und ein Teil der leitfähigen Leitung (L), der die Schleife bildet, sich in der Längsrichtung der Batteriezelle (10) entlang einer unteren Fläche des Spannvorrichtungskörpers (100) erstreckt,
wobei die Impedanzmessplatte (400) an der unteren Fläche des Spannvorrichtungskörpers (100) installiert ist und der Teil der leitfähigen Leitung (L), der die Schleife bildet, zu beiden Seiten der Impedanzmessplatte (400) herausgezogen ist und sich in Richtung sowohl der ersten Sammelschiene (200) als auch der zweiten Sammelschiene (300) erstreckt.

2. Lade- und Entladevorrichtung nach Anspruch 1, wobei die leitfähige Leitung zur Impedanzmessung eine Signalleitung (L1), die konfiguriert ist, um ein Wechselstromsignal an die Batteriezelle (10) anzulegen, und eine Erfassungsleitung (L2) aufweist, die konfiguriert ist, eine Spannung der Batteriezelle (10) zu messen.

3. Lade- und Entladevorrichtung nach Anspruch 2, wobei die erste Sammelschiene (200) und die zweite Sammelschiene (300) als eine obere Sammelschiene (210, 310) und eine untere Sammelschiene (220, 320) gebildet sind und die leitfähige Leitung (L) zur Impedanzmessung mit der oberen Sammelschiene (210, 310) oder der unteren Sammelschiene (220, 320) verbunden ist.

4. Lade- und Entladevorrichtung nach Anspruch 3, wobei die oberen Sammelschienen (210, 310) der ersten Sammelschiene (200) und der zweiten Sammelschiene (300) jeweils in zwei Sammelschienen getrennt sind und die Signalleitung (L1) und die Erfassungsleitung (L2) mit jeder der getrennten Sammelschienen verbunden sind.

5. Lade- und Entladevorrichtung nach Anspruch 2, wobei die Impedanzmessplatte (400) eine Wechselstromsignalquelle (S) und einen Strommesser (A), der mit der Signalleitung (L1) verbunden ist, und einen Spannungsmesser (V) aufweist, der mit der Erfassungsleitung (L2) verbunden ist.

6. Lade- und Entladevorrichtung nach Anspruch 1, die ferner Sockel (260, 360) aufweist, die an beiden unteren Seiten des Spannvorrichtungskörpers (100) installiert sind, wobei die Impedanzmessplatte (400) an den Sockeln (260, 360) oder dem unteren Teil des Spannvorrichtungskörpers (100) angrenzend an die Sockel (260, 360) installiert ist.

7. Lade- und Entladevorrichtung nach Anspruch 1, die ferner Sockel (260, 360) aufweist, die an beiden unteren Seiten des Spannvorrichtungskörpers (100) installiert sind, wobei die Impedanzmessplatte (400) an einem Messplattenträger (410) installiert ist, der mit den Sockeln (260, 360) gekoppelt ist.

8. Lade- und Entladevorrichtung nach Anspruch 1, wobei ein leitfähiges Leitungsträgerelement (500), das konfiguriert ist, um die leitfähige Leitung (L) zur Impedanzmessung zu tragen, die sich in der Längsrichtung der Batteriezelle (10) entlang der unteren Fläche des Spannvorrichtungskörpers (100) erstreckt, an der unteren Fläche des Spannvorrichtungskörpers (100) installiert ist.

9. Lade- und Entladevorrichtung nach Anspruch 1, wobei Befestigungsspannvorrichtungen (600), die konfiguriert sind, um beide Seiten einer leitfähigen Leitung (L) zu befestigen, die sich in der Längsrichtung der Batteriezelle (10) entlang der unteren Fläche des Spannvorrichtungskörpers (100) erstreckt, an beiden Seiten der unteren Fläche des Spannvorrichtungskörpers (100) installiert sind.

10. Lade- und Entladevorrichtung nach Anspruch 1, wobei der Spannvorrichtungskörper (100) einen festen Block (110) und einen beweglichen Block (120) aufweist, der verschiebbar mit dem festen Block (110) gekoppelt ist, und
die erste Sammelschiene (200) an einer Seite des festen Blocks (110) installiert ist und die zweite Sammelschiene (300) an einer Seite des beweglichen Blocks (120) installiert ist.

11. Lade- und Entladevorrichtung nach Anspruch 10, wobei der bewegliche Block (120) verschiebbar mit einer oberen Fläche des festen Blocks (110) gekoppelt ist.

12. Lade- und Entladevorrichtung nach Anspruch 11, wobei Führungsschlitze (140) an beiden Seiten in einer Breitenrichtung von einem von dem festen Block (110) und dem beweglichen Block (120) ausgebildet sind, und
verschiebbare Trägerelemente (130), die in die Führungsschlitze (140) eingesetzt sind, an dem anderen von dem festen Block (110) und dem beweglichen Block (120) installiert sind.

13. Lade- und Entladevorrichtung nach Anspruch 12, wobei jedes der verschiebbaren Trägerelemente (130) einen Körperteil, der in den Führungsschlitz (140) eingesetzt und mit dem festen Block (110) oder dem beweglichen Block (120) verschraubt ist, und einen Kopfteil mit einer Breite aufweist, die größer als die des Führungsschlitzes (140) ist.

## Revendications

1. Dispositif de montage de charge et de décharge pour une mesure de l'impédance d'une cellule de batterie (10), le dispositif de montage de charge et de décharge comprenant :
un corps de dispositif de montage (100) sur lequel une cellule de batterie (10) est montée dans une direction longitudinale ; et
une première barre omnibus (200) et une deuxième barre omnibus (300) installées sur une surface supérieure au niveau des deux côtés du corps de dispositif de montage (100) et auxquelles des parties de fils (11, 12) des deux extrémités de la cellule de batterie (10) sont couplées individuellement,
**caractérisé par**
un tableau de mesure d'impédance (400) installé dans le corps de dispositif de montage (100) ; et
une ligne conductrice (L) pour une mesure de l'impédance connectant la première barre omnibus (200), le tableau de mesure d'impédance (400), et la deuxième barre omnibus (300) afin de constituer un circuit de mesure d'impédance,
dans lequel une partie de la ligne conductrice (L) pour la mesure de l'impédance a une partie faisant face à une large surface de la cellule de batterie (10) et s'étendant dans la direction longitudinale de la cellule de batterie (10),
dans lequel le tableau de mesure d'impédance (400) est installé au milieu de la surface inférieure du corps de dispositif de montage (100) dans la direction longitudinale, la ligne conductrice (L) pour la mesure de l'impédance constitue une boucle connectant la première barre omnibus (200), le tableau de mesure d'impédance (400), et la deuxième barre omnibus (300), et une partie de la ligne conductrice (L) constituant la boucle s'étend dans la direction longitudinale de la cellule de batterie (10) le long d'une surface inférieure du corps de dispositif de montage (100),
dans lequel le tableau de mesure d'impédance (400) est installé sur la surface inférieure du corps de dispositif de montage (100), et la partie de la ligne conductrice (L) constituant la boucle est étirée vers les deux côtés du tableau de mesure d'impédance (400) et s'étend vers chaque barre omnibus parmi la première barre omnibus (200) et la deuxième barre omnibus (300).

2. Dispositif de montage de charge et de décharge de la revendication 1, dans lequel la ligne conductrice pour la mesure de l'impédance inclut une ligne de signaux (L1) configurée pour appliquer un signal CA à la cellule de batterie (10), et une ligne de détection (L2) configurée pour mesurer une tension de la cellule de batterie (10).

3. Dispositif de montage de charge et de décharge de la revendication 2, dans lequel la première barre omnibus (200) et la deuxième barre omnibus (300) sont chacune constituées comme une barre omnibus supérieure (210, 310) et une barre omnibus inférieure (220, 320), et la ligne conductrice (L) pour une mesure de l'impédance est connectée à la barre omnibus supérieure (210, 310) ou à la barre omnibus inférieure (220, 320).

4. Dispositif de montage de charge et de décharge de la revendication 3, dans lequel les barres omnibus supérieures (210, 310) de la première barre omnibus (200) et de la deuxième barre omnibus (300) sont chacune séparées en deux barres omnibus, et la ligne de signaux (L1) et la ligne de détection (L2) sont connectées à chacune des barres omnibus séparées.

5. Dispositif de montage de charge et de décharge de la revendication 2, dans lequel le tableau de mesure d'impédance (400) inclut une source de signaux CA (S) et un ampèremètre (A) connecté à la ligne de signaux (L1), et un voltmètre (V) connecté à la ligne de détection (L2).

6. Dispositif de montage de charge et de décharge de la revendication 1, comprenant en outre des socles (260, 360) installés sur les deux côtés inférieurs du corps de dispositif de montage (100), dans lequel le tableau de mesure d'impédance (400) est installé sur les socles (260, 360) ou la partie inférieure du corps de dispositif de montage (100) adjacente aux socles (260, 360).

7. Dispositif de montage de charge et de décharge de la revendication 1, comprenant en outre des socles (260, 360) installés sur les deux côtés inférieurs du corps de dispositif de montage (100), dans lequel le tableau de mesure d'impédance (400) est installé sur un support de tableau de mesure (410) couplé aux socles (260, 360).

8. Dispositif de montage de charge et de décharge de la revendication 1, dans lequel un élément de support de ligne conductrice (500) configuré pour soutenir la ligne conductrice (L) pour une mesure de l'impédance s'étendant dans la direction longitudinale de la cellule de batterie (10) le long de la surface inférieure du corps de dispositif de montage (100) est installé sur la surface inférieure du corps de dispositif de montage (100).

9. Dispositif de montage de charge et de décharge de la revendication 1, dans lequel des dispositifs de montage de fixation (600) configurés pour fixer les deux côtés d'une ligne conductrice (L) s'étendant dans la direction longitudinale de la cellule de batterie (10) le long de la surface inférieure du corps de dispositif de montage (100) sont installés sur les deux côtés de la surface inférieure du corps de dispositif de montage (100).

10. Dispositif de montage de charge et de décharge de la revendication 1, dans lequel le corps de dispositif de montage (100) inclut un bloc fixe (110) et un bloc mobile (120) couplé de manière coulissante au bloc fixe (110), et
la première barre omnibus (200) est installée sur un côté du bloc fixe (110) et la deuxième barre omnibus (300) est installée sur un côté du bloc mobile (120).

11. Dispositif de montage de charge et de décharge de la revendication 10, dans lequel le bloc mobile (120) est couplé de manière coulissante sur une surface supérieure du bloc fixe (110).

12. Dispositif de montage de charge et de décharge de la revendication 11, dans lequel des fentes de guidage (140) sont formées sur les deux côtés dans une direction de largeur d'un bloc parmi le bloc fixe (110) et le bloc mobile (120), et
des éléments de support coulissants (130) insérés dans les fentes de guidage (140) sont installés sur l'autre bloc parmi le bloc fixe (110) et le bloc mobile (120).

13. Dispositif de montage de charge et de décharge de la revendication 12, dans lequel chacun des éléments de support coulissants (130) a une partie de corps qui est insérée dans la fente de guidage (140) et vissée sur le bloc fixe (110) ou le bloc mobile (120), et une partie de tête ayant une largeur plus grande que celle de la fente de guidage (140).
